# EUROPEAN PATENT APPLICATION

(11) **EP 2 725 613 A1**
(43) Date of publication of application: **30.04.2014**
(21) Application number: 12007372.1
(22) Date of filing: 26.10.2012
(51) Int. Cl.: H01L 25/16, H01L 27/02, H01L 27/15, H05B 33/08

(54) **An LED having two pins that handle contingencies of open, static electricity, and surge**

(71) Applicant: Ceramate Technical (Suzhou) Co., Ltd., 215011 Jiangsu (CN)
(72) Inventor: Wang, Robert, Taoyuan County (TW); Chen, Michael, Taoyuan County (TW); Huang, Ethan, Taoyuan County (TW)
(74) Representative: Zeitler - Volpert - Kandlbinder

(57) **Abstract**

An LED having two pins that handle contingencies of open, static electricity, and surge comprises an LED cell (10), a thyristor (20), such as SCR, with three electrodes arranged in series connection to the LED cell, a transistor (30) for a gate of the thyristor to trigger signals, and a voltage detecting circuit (40). When the LED cell breaks due to open, a proper current is acquired via the voltage detecting circuit so as to trigger the SCR, thereby providing a substitute current route that allows the rest of the serially-connected LED cells to keep lighting. When static electricity or surge occurs at two ends of the LED cells, the SCR provides a route to guide the static electricity or the surge, which protects the LED cells.

## Description

### 1. Field of the Invention

The present invention relates to an LED, especially to an LED having two pings that handle contingencies of open, static electricity, and surge.

### 2. Description of the Prior Art

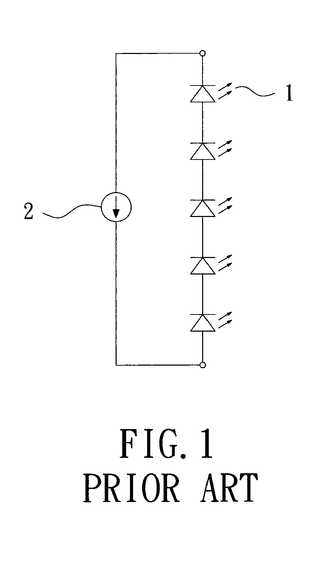

LED (Light Emitting Diode) is expansively applied in illumination, advertisement, industry, army, and so on, which encourages the development of electronic industry. LED is a kind of semiconductor that directly transforms electricity to light. Wherein, the LED is commonly served as a light source in light indicators or other like electronic appliances. In addition, large-sized displays, such as large-sized neon or LCD backlight boards need lots of LED to provide sufficient light. Fig. 1 shows a conventional LED circuit that includes several LEDs 1 arranged in series connection and coupled to a power source 2. In view of the series connection, each LED 1 receives the same current, so each LED 1 provides the same illumination. Nonetheless, if any one of the LEDs 1 in the LED circuit breaks, the broken LED 1 results in open and stops a current route. As a result, even other LEDs 1 are not broken, they can not function. Moreover, when static electricity or surge occurs at two ends of the LEDs 1 arranged in series connection, the LEDs 1 break easily.

### SUMMARY OF THE INVENTION

The object of the present invention is to provide an LED having two pins that handle contingencies of open, static electricity, and surge.

The present invention in accordance with afore object comprises an LED cell; an SCR (Silicon-Controlled Rectifier) adopting a thyristor with three electrodes; the SCR and the LED cell being coupled in parallel connection; a second anode of the SCR being connected to a first anode of the LED cell, and a second cathode of the SCR being connected to a first cathode of the LED cell; a transistor having an emitter connected to a first gate of the SCR, and a collector connected to the second anode of the SCR; and a voltage detecting circuit adopting a voltage dividing circuit with a first resistance and a second resistance; a base of the transistor being connected to one end of the first resistance and one end of the second resistance; the other end of the first resistance being connected to the second anode of the SCR, and the other end of the second resistance being connected to the second cathode of the SCR.

When one LED cell in the series connection breaks in view of open, the SCR is triggered by the LED from proper current via the voltage detecting circuit so as to offer another available current route. Accordingly, other normal LED cells are not influenced and they can function well. Moreover, if static electricity or surge occurs at two ends of the LED cells in series connection, the SCR provides a route to guide the static electricity or surge so as to protect the LED cells.

### BRIEF DESCRIPTION OF THE DRAWINGS

Fig. 1 is circuit diagram showing a conventional LED arranged in series connection;
Fig. 2 is a circuit diagram of a first preferred embodiment of the present invention;
Fig. 3 is a schematic view showing the first preferred embodiment of the present invention packed with two pins;
Fig. 4 is a schematic view showing the first preferred embodiment of the present invention in use;
Fig. 5 is a circuit diagram of a coupled diode in the first preferred embodiment of the present invention;
Fig. 6 is a circuit diagram of a coupled Shockley Diode in the first preferred embodiment of the present invention; and
Fig. 7 is a circuit diagram of a second preferred embodiment of the present invention.

### DETAILED DESCRIPTION OF THE PREFERRED EMBODIMENTS

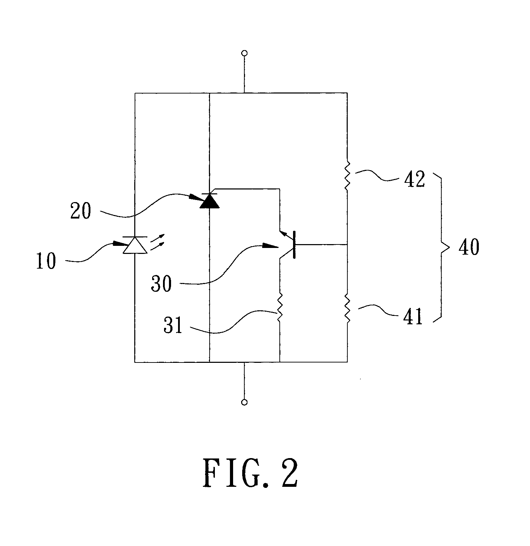

Fig. 2 shows a circuit diagram of a first preferred embodiment of the present invention. An LED having two pins that handle contingencies of open, static electricity, and surge comprises an LED cell 10, an SCR 20, a transistor 30, and a voltage detecting circuit 40.

The LED cell 10 adopts an unpacked LED that has a first anode and a first cathode.

The SCR (Silicon-Controlled Rectifier) 20 adopts a thyristor with three electrodes; the SCR 20 has a second anode, a second cathode, and a first gate; the second anode of the SCR 20 is connected to the first anode of the LED cell 10, and the second cathode of the SCR 20 is connected to the first cathode of the LED cell 10.

The transistor 30 adopts an NPN transistor; an emitter of the transistor 30 is connected to a first gate of the SCR 20, and a collector of the transistor 30 is connected to the second anode of the SCR 20; a current limiting resistance 31 is disposed between the collector of the transistor 30 and the second anode of the SCR 20.

The voltage detecting circuit 40 adopts a voltage dividing circuit with a first resistance 41 and a second resistance 42; a base of the transistor 30 is connected to one end of the first resistance 41 and one end of the second resistance 42; the other end of the first resistance 41 is connected to the second anode of the SCR 20, and the other end of the second resistance 42 is connected to the second cathode of the SCR 20.

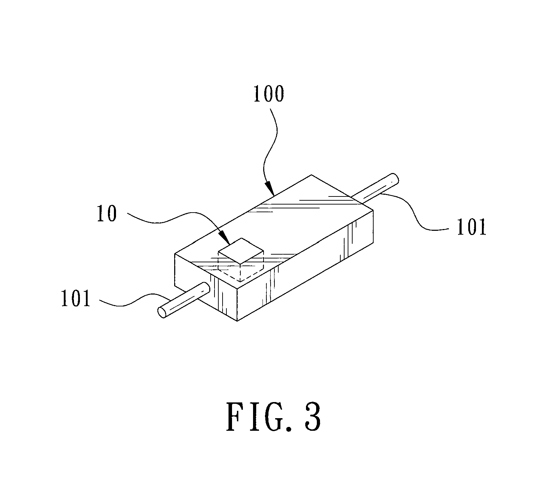

Fig. 3 shows a schematic view of the present invention packed with two pins. The LED cell 10, the SCR 20, the transistor 30, and the voltage detecting circuit 40 are arranged on a same plate for being packed, thereby contributing to an integrated and compound LED 100. A pin 101 is extended from two sides of the LED 100, respectively, for electrically connecting to an external power source.

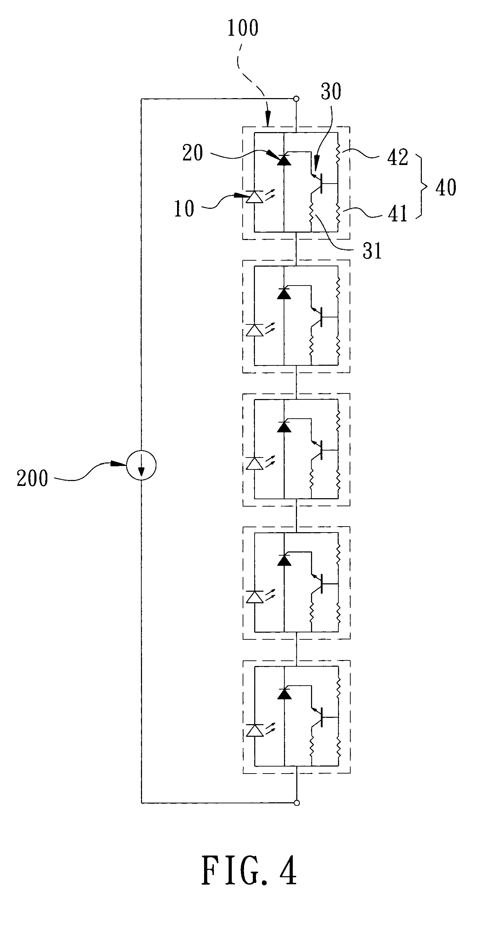

Fig. 4 shows a schematic view of the present invention in using. Wherein, several LEDs 100 are arranged in series connection, and the integral LEDs 100 are further coupled to a power source 200 in parallel connection. When any one of the LED cells 10 in the LED 100 breaks in view of open, the LED 100 utilizes the voltage detecting circuit 40 to acquire a proper current for triggering the SCR 20, which offers a substitute current route. Thereby, other normal LED cells 10 in the LED 100 can still function well. Moreover, when static electricity or surge occurs at two ends of the LED 100, the SCR 20 also provides a route to guide the static electricity or the surge, so that the LED cell 10 is protected.

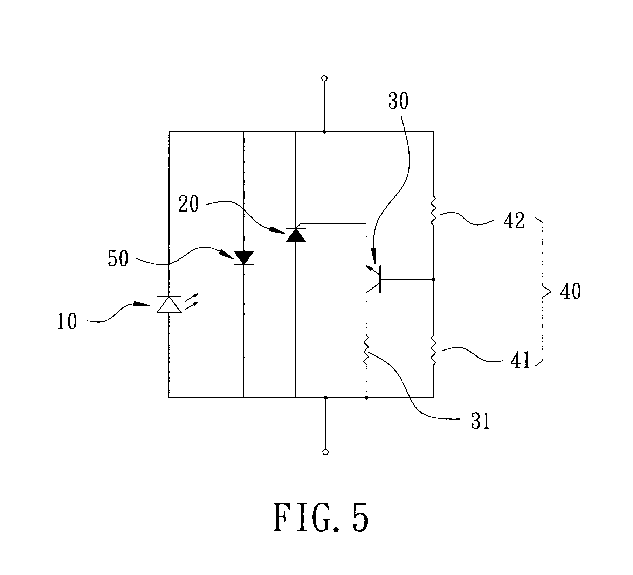

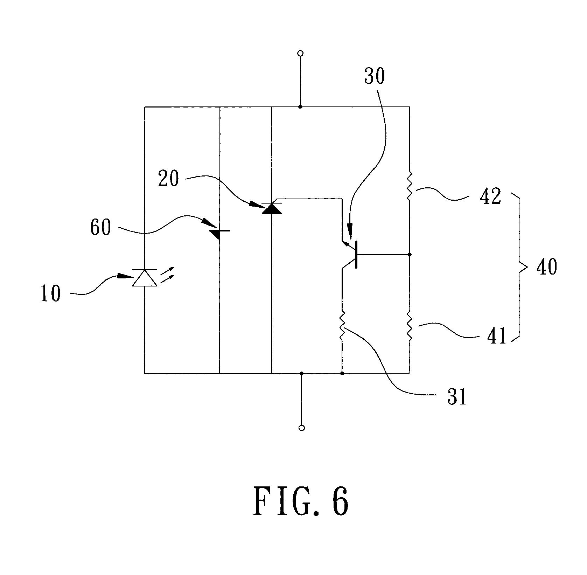

In order to prevent the LED cell 10 from breaking due to static electricity, electricity discharging, or reverse polarity, the SCR 20 is coupled to a reverse diode as shown in Fig. 5 of a circuit diagram of a coupled diode of the present invention. The SCR 20 is coupled to a reversed diode 50, so that a third anode of the diode 50 is connected to the second cathode of the SCR 20, and a third cathode of the diode 50 is connected to the second anode of the SCR 20. Accordingly, the diode 50 provides a reverse protection. Additionally, the SCR 20 of the present invention could be further coupled to a reversed Shockley Diode as shown in a circuit diagram in Fig. 6. When the SCR 20 is coupled to a reversed Shockley Diode 60, a fourth anode of the Shockley Diode 60 is connected to the second cathode of the SCR 20, and a fourth cathode of the Shockley Diode 60 is connected to the second anode of the SCR 20. Thereby, a similar reverse protection is provided.

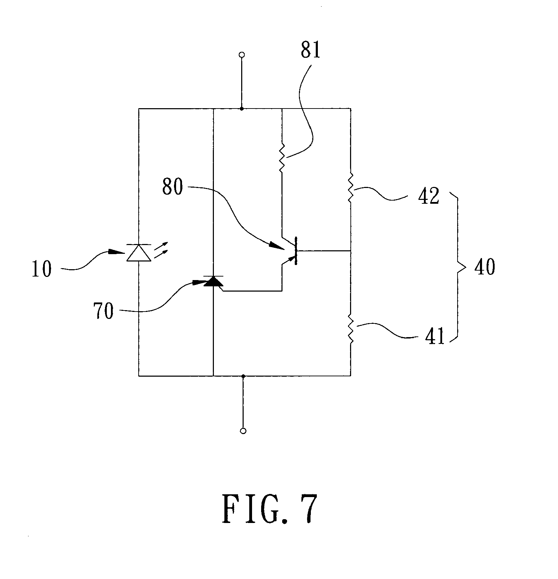

Fig. 7 shows a further circuit diagram of the present invention that discloses an LED including LED cells 10, a PUT 70, a transistor 80, and a voltage detecting circuit 40. The LED cells 10,the PUT 70, the transistor 80, and the voltage detecting circuit 40 are arranged on a same plate for being packed, thereby contributing to an integrated and compound LED.

The LED cells 10 adopt an unpacked LED that has a first anode and a first cathode.

The PUT 70 (Programmable Uni-junction Transistor) adopts a thyristor with three electrodes; a fifth anode of the PUT 70 is connected to a first anode of the LED cells 10, and a fifth cathode of the PUT 70 is connected to a first cathode of the LED cells 10.

The transistor 80 adopts a PNP transistor; an emitter of the transistor 80 is connected to a second gate of the PUT 70, and a collector of the transistor 80 is connected to the fifth anode of the PUT 70; a current limiting resistance 81 is disposed between the collector of the transistor 80 and the fifth anode of the PUT 70.

The voltage detecting circuit 40 adopts a voltage dividing circuit with a first resistance 41 and a second resistance 42; a base of the transistor 80 is connected to one end of the first resistance 41 and one end of the second resistance 42; the other end of the first resistance 41 is connected to the fifth anode of the PUT 70, and the other end of the second resistance 42 is connected to the fifth cathode of the PUT 70.

When any one of the LED cells 10 in the LED breaks in view of open, the LED utilizes the voltage detecting circuit 40 to acquire a proper current for triggering the PUT 70, which offers a substitute current route. Moreover, when static electricity or surge occurs at two ends of the LED cells 10, the voltage between the first anode and the first cathode of the LED allows the base of the transistor 80 to generate current. Namely, the emitter of the transistor 80 offers sufficient current, and the second gate of the PUT 70 could be triggered. Accordingly, the PUT 70 starts breakover. When the current generated from surge or static electricity enters the PUT 70 through the fifth anode of the PUT 70, the current further flows out from the fifth cathode of the PUT 70. Preferably, the PUT 70 provides a route to guide the static electricity and the surge, so that the LED cells 10 are protected.

The present invention has advantageous as follows:
1. When the LED cell of the present invention breaks due to open, the LED acquires a proper current via the voltage detecting circuit so as to trigger the thyristor SCR or PUT, thereby providing a substitute current route. Preferably, the rest of the LEDs in series connection still function well.
2. When the surge or the static electricity invades the LED of the present invention, the voltage detecting circuit in the LED acquires a proper current for triggering the thyristor SCR or PUT. Namely, a route is provided for guiding the surge or the static electricity so as to protect the LED cells.

## Claims

1. An LED having two pings that handle contingencies of open, static electricity, and surge comprising:
an LED (Light Emitting Diode) cell;
an SCR (Silicon-Controlled Rectifier) adopting a thyristor with three electrodes; wherein, said SCR and said LED cell being coupled in parallel connection; a second anode of said SCR being connected to a first anode of said LED cell, and a second cathode of said SCR being connected to a first cathode of said LED cell;
a transistor adopting an NPN transistor; an emitter of said transistor being connected to a first gate of said SCR, and a collector of said transistor being connected to said second anode of said SCR; and
a voltage detecting circuit adopting a voltage dividing circuit with a first resistance and a second resistance in series connection; wherein, a base of said transistor being connected to one end of said first resistance and one end of said second resistance; the other end of said first resistance being connected to said second anode of said SCR, and the other end of said second resistance being connected to said second cathode of said SCR.

2. The LED as claimed in claim 1, wherein, a current limiting resistance is disposed between said collector of said transistor and said second anode of said SCR.

3. The LED as claimed in claim 1, wherein, said LED cell, said SCR, said transistor, and said voltage detecting circuit are arranged on a same plate for being packed, thereby contributing to an integrated and compound LED.

4. An LED having two pins that handle contingencies of open, static electricity, and surge comprising:
an LED (Light Emitting Diode) cell;
a PUT (Programmable Uni-junction Transistor) adopting a thyristor with three electrodes; a fifth anode of said PUT being connected to a first anode of said LED cell, and a fifth cathode of said PUT being connected to a first cathode of said LED cell;
a transistor adopting a PNP transistor; an emitter of said transistor being connected to a second gate of said PUT, and a collector of said transistor being connected to said fifth anode of said PUT; and
a voltage detecting circuit adopting a voltage dividing circuit with a first resistance and a second resistance in series connection; a base of said transistor being connected to one end of said first resistance and one end of said second resistance; the other end of said first resistance being connected to said fifth anode of said PUT, and the other end of said second resistance being connected to said fifth cathode of said PUT.

5. The LED as claimed in claim 4, wherein, a current limiting resistance is disposed between said collector of said transistor and said fifth anode of said PUT.

## Amended claims

### Amended claims in accordance with Rule 137(2) EPC.

**1.** An LED having two pins that handle contingencies of open, static electricity, and surge comprising:
an LED (Light Emitting Diode) cell (10);
an SCR (Silicon-Controlled Rectifier) (20) adopting a thyristor with three electrodes; wherein, said SCR and said LED cell being coupled in parallel connection; an anode of said SCR being connected to an anode of said LED cell, and a cathode of said SCR being connected to a cathode of said LED cell; and
a voltage detecting circuit (40) adopting a voltage dividing circuit with a first resistance (41) and a second resistance (42) in series connection, **characterized by** a transistor (30) adopting an NPN transistor; an emitter of said transistor (30) being connected to a gate of said SCR (20), and a collector of said transistor (30) being connected to said anode of said SCR (20),
wherein a base of said transistor (30) being connected to one end of said first resistance (41) and one end of said second resistance (42); the other end of said first resistance (41) being connected to said anode of said SCR (20), and the other end of said second resistance (42) being connected to said cathode of said SCR (20).

**2.** The LED as claimed in claim 1, wherein, a current limiting resistance (31) is disposed between said collector of said transistor (30) and said anode of said SCR (20).

**3.** The LED as claimed in claim 1, wherein, said LED cell (10), said SCR (20), said transistor (30), and said voltage detecting circuit (40) are arranged on a same plate for being packed, thereby contributing to an integrated and compound LED.

**4.** An LED having two pins that handle contingencies of open, static electricity, and surge comprising:
an LED (Light Emitting Diode) cell (10);
a PUT (Programmable Uni-junction Transistor) (70) adopting a thyristor with three electrodes; an anode of said PUT (70) being connected to an anode of said LED cell (10), and a cathode of said PUT (70) being connected to a cathode of said LED cell (10); and
a voltage detecting circuit (40) adopting a voltage dividing circuit with a first resistance (41) and a second resistance (42) in series connection; **characterized by** a transistor (80) adopting a PNP transistor; an emitter of said transistor (80) being connected to a gate of said PUT (70), and a collector of said transistor (80) being connected to said anode of said PUT (70),
wherein a base of said transistor (80) being connected to one end of said first resistance (41) and one end of said second resistance (42); the other end of said first resistance (41) being connected to said anode of said PUT (70), and the other end of said second resistance (42) being connected to said cathode of said PUT (70).

**5.** The LED as claimed in claim 4, wherein, a current limiting resistance (81) is disposed between said collector of said transistor (80) and said anode of said PUT (70).
